# EUROPÄISCHE PATENTSCHRIFT

(11) **EP 2 311 066 B1**
(45) Veröffentlichungstag und Bekanntmachung des Hinweises auf die Patenterteilung: **13.11.2013**
(21) Anmeldenummer: 09777647.0
(22) Anmeldetag: 04.08.2009
(51) Int. Cl.: H01J 37/32, C23C 16/511

(54) **Vorrichtung und Verfahren zur Erzeugung dielektrischer Schichten im Mikrowellenplasma**
Device and method for producing dielectric layers in microwave plasma
Dispositif et procédé pour générer des couches diélectriques dans un plasma micro-ondes

(30) Priorität: 07.08.2008 DE 102008036766
(43) Veröffentlichungstag der Anmeldung: 20.04.2011
(73) Patentinhaber: HQ-Dielectrics GmbH, 89160 Dornstadt (DE)
(72) Erfinder: LERCH, Wilfried, 89160 Dornstadt-Tomerdingen (DE); NENYEI, Zsolt, 89134 Blaustein (DE); THEILER, Thomas, 89081 Ulm (DE); GSCHWANDTER, Alexander, 80687 München (DE)
(74) Vertreter: Klang, Alexander H.
(86) Internationale Anmeldenummer: PCT/EP2009/005644
(87) Internationale Veröffentlichungsnummer: WO 2010/015385

(56) Entgegenhaltungen:
- EP-A- 0 410 706
- DE-A1- 4 136 297
- DE-A1- 19 722 272
- DE-A1-102004 039 468
- DE-A1-102006 048 814

## Beschreibung

Die Erfindung betrifft eine Vorrichtung zum Erzeugen eines Mikrowellenplasmas, sowie eine Vorrichtung und ein Verfahren zum Behandeln von Halbleitersubstraten mit einem Mikrowellenplasma. Insbesondere sollen entsprechend der erfindungsgemäßen Vorrichtung und dem erfindungsgemäßen Verfahren fehlerfreie dielektrische Schichten im Mikrowellenplasma bei Raumtemperatur oder leicht erhöhter Temperatur auf Halbleiterprozeßscheiben erzeugt werden.

Bei der Herstellung von elektronischen Bauelementen, wie Speicherchips, Mikroprozessoren, kundenspezifischen Schaltungsausführungen oder Logikbauelementen sind sehr präzise und zuverlässig arbeitende Halbleiterfertigungsgeräte erforderlich. Das zu fertigende Produkt, in vielen Fällen ein Halbleiterbauelement, für dessen Herstellung oft mehrere hundert Einzelprozeßschritte durchgeführt werden müssen, soll elektrisch zuverlässig arbeiten und reproduzierbare elektrische und physikalische Eigenschaften aufweisen. Dabei stellt der Trend zu immer kleineren Strukturen, oder mit anderen Worten die immer größere Anzahl von Halbleiterbauelementen pro Quadratzentimeter die Halbleiterfertigungsgerätehersteller vor immer neue Herausforderungen. Damit bei 45 nm-Halbleiterstrukturen, bei 32 nm-Halbleiterstrukturen und darunter noch Halbleiterbauelemente, bespielsweise Logikbausteine mit einer ebenso zuverlässigen elektrischen Funktionsweise, wie dies bei 65 nm Logik-Halbleiterstrukturen der Fall ist, hergestellt werden können, ist die Herstellung von fehlerfreien Isolatorschichten bei niedrigen Temperaturen ein vordringliches Problem. So wird zum Beispiel von der Automobilindustrie gefordert, dass die dort eingesetzten elektronischen Bauelemente über einen langen Zeitraum fehlerfrei funktionieren, da von deren zuverlässigen Funktionsweise Menschenleben abhängen können. Um diesen Anforderungen zu entsprechen muss die Zuverlässigkeit der Bauelemente entsprechend verbessert werden, wobei unter Anderem ein wesentlicher Ansatz darin besteht, dass dielektrische Schichten fehlerfrei erzeugt oder durch entsprechende Nachbehandlung in einen fehlerfreien Zustand versetzt werden können.

Ein weitere Forderung der gegenwärtigen Halbleitertechnologie besteht, wie bereits oben erwähnt, in der Senkung des thermischen Budgets bei der Herstellung von beispielsweise thermischen Oxidschichten, oder anderer dielektrischer Schichten.

Weiterhin sind beispielsweise neue Forderungen in der Transistorentwicklung mit sogenannten "metal-gates" von Mikroprozessoren zu erfüllen. So soll beispielsweise eine selektive Oxidation von Silizium zu den Materialien Wolfram, Wolframsilizid, Tantalnitrid, Titannitrid etc. bei geringer Temperatur erfolgen können.

Eine weitere Forderung ist eine gleichmäßige Oxidation von Halbleiterstrukturen bestehend aus unterschiedlich dotiertem Silizium und die Oxidation von Siliziumnitrid. Darüber hinaus erfordert die Herstellung zuverlässig arbeitender Halbleiterbauelemente die Erzeugung von fehlerfreien Schichten mit großer Dielektrizitätskonstante auf Tantal, Niob bzw. Tantalnitrid, Niobnitrid und ähnlichen Materialien so wie die Nachbehandlung von fehlerhaften Schichten, die durch CVD- bzw. ALD-Verfahren abgeschieden wurden.

Bisher werden dielektrische Schichten durch thermische Oxidation im Ofen oder in RTP-Reakoren, bzw. durch CVD- oder neuerdings durch ALD-Verfahren erzeugt, die jedoch insgesamt aufgrund ihrer jeweiligen Herstellungsverfahren im Hinblick auf ihre elektrischen Eigenschaften nicht fehlerfreie Schichten erzeugen. So können bei der thermischen Oxidation Verunreinigungen bzw. Störungen der Kristallstruktur zu elektrisch fehlerhaften Schichten führen. Bei CVD- und ALD Schichten sind, insbesondere bei dünnen Schichten, Bekeimungsprobleme Ursache für elektrische Schwachstellen, ebenso Einschlüsse von Partikeln.

Ein weiterer Nachteil der thermischen Oxidation ist das sogenannte thermische Budget, unter dem man das Produkt aus Temperatur multipliziert mit der dabei verstrichenen Zeit versteht. Bei sehr vielen Prozessen der Halbleiterfertigung, wie thermische Oxidation oder auch Nitridierung ist das thermische Budget zum erforderlichen Schichtaufbau so groß, dass beim Schichtaufbau signifikante Schädigungen des Halbleiterbauelements verursacht werden können. So werden z.B. bei zu großem Temperaturbudget die Diffusionsprofile der Dotierstoffe verwaschen, was die Zuverlässigkeit der Bauelemente verschlechtert.

Ein anderer Nachteil der thermischen Oxidation besteht darin, dass unterschiedlich dotiertes und kristallin orientiertes Silizium mit unterschiedlicher Geschwindigkeit oxidiert wird, was z.B. zu einer kristallorientierungsabhängigen unterschiedlichen Durchbruchspannung des Oxids führen kann. Dies stellt ein erhebliches Problem in der Halbleiterfertigung dar.

Ein anderer Nachteil der thermischen Oxidation besteht darin, dass bei der Oxidation von Silizium das Siliziumnitrid nur minimal oxidiert wird. Bei gegenwärtig eingesetzten Halbleiterbauelementen gibt es Strukturen, bei denen sich unmittelbar neben der Siliziumoberfläche ein Siliziumnitrid befindet. Bei solchen Strukturen können thermische Oxidationsprozesse nur begrenzt zum Einsatz kommen, bzw. überhaupt nicht angewendet werden, da sich bei derartigen Oxidationsprozessen im Übergangsbereich zwischen der Siliziumoberfläche und der Siliziumnitridschicht keine Oxidschicht, oder nicht die gewünschte Oxidschicht ausbildet.

In der Literatur sind Verfahren bekannt, welche diese Nachteile versuchen, zu beheben. So beschreibt die EP1018150 beispielsweise ein Verfahren zur Bildung eines Oxids, wobei ein Substrat auf eine Temperatur aufgeheizt wird, welche ausreichend hoch ist, eine Rekation zwischen einem sauerstoffhaltigen Gas und Wasserstoffgas in einer Prozeßkammer in der Nähe des Substrats zu initiieren. Bei diesem bekannten Verfahren wird bei einem Druck von ca. 1/100 des Atmosphärendrucks gleichzeitig Wasserstoff und Sauerstoff auf die erhitzte Silizumscheibe geleitet und so bei erhöhter Temperatur ab ca. 850 Grad Celsius eine dünne Oxidschicht auf Silizum und Siliziumnitrid erzeugt. Diese Art der Oxidation, auch unter dem Namen in-situ Naßoxidation in der Literatur bekannt, liefert jedoch allenfalls geringe Oxidschichtdicken und benötigt darüber hinaus eine in vielen Fällen inakzeptabel hohe Temperatur.

Mit derartigen Verfahren ist beispielsweise keine selektive Oxidation von Silizium zu Metallen bei Zimmertemperatur bzw. einer Temperatur von wenigen hundert Grad Celsius möglich.

Schichten mit großer Dielektrizitätskonstante, insbesondere kristalline Schichten können auf großen Flächen nicht fehlerfrei abgeschieden werden.

Derzeit gibt es Vorrichtungen, mit denen versucht wird, eine Oxidation von Silizium auf Basis von RF-Anregung eines Plasmas zu erreichen. So offenbart beispielsweise die US 7,214,628 ein Verfahren zur Gateoxidation, wobei eine Vorrichtung verwendet wird, in welcher ein mit gepulster Mikrowellenstrahlung betriebenes induktiv erzeugtes Plasma verwendet wird. Das Plasma wird bei diesem Verfahren bewusst in einem hinreichend großen Abstand zum Substrat gehalten, damit ionengenerierte Defekte in einer sich bildenden Oxidschicht möglichst vermieden werden. Das Plasma wird an- und ausgeschaltet. Während der Off-Intervalle können Ionen aus dem Plasma auf das Substrat gelangen. Während der Bildung der Oxidschicht werden Kammerdruck und Pulszyklus so limitiert, daß die durch das lonenbombardement in der Oxidschicht induzierten Defekte möglichst klein gehalten werden. Das in dieser Vorrichtung verwendete Plasma erreicht jedoch nicht die Dichte an niederenergetischen Ionen und Elektronen, die erforderlich ist, um die gewünschten Effekte zu erzielen, d.h. um innerhalb kurzer Zeit eine Schicht mit einer hinreichenden Dicke auf dem Substrat zu erzeugen.

Die US 2007/0221294 A1 beschreibt ebenfalls eine auf Mikrowellenbasis arbeitende plasmaerzeugende Vorrichtung zur Erzeugung eines Oxid- oder Nitridfilms. Bei dieser Vorrichtung wird, um möglichst homogene Oxid- bzw. Nitridschichten zu erzeugen, ein Mikrowellenplasma durch eine vom zu behandelnden Substrat beabstandete Verteilerplatte auf das Substrat gelenkt. Auch dieses Mikrowellenplasma weist, auf Grund der Art seiner Zuführung in die Prozeßkammer nicht die zur Erzielung der gewünschten Effekte notwendige Plasmadichte auf.

Die DE 197 22 272 A1 zeigt eine Vorrichtung zur Erzeugung von Plasma. Die Vorrichtung weist einen Koaxial-Innenleiter, einen ersten Koaxial-Außenleiter sowie einen zweiten Koaxial-Außenleiter auf. Der Koaxial-Innenleiter ist beidseitig mit einer ersten Quelle für elektromagnetische Wechselfelder verbunden und der erste Koaxial-Außenleiter ist beidseitig mit einer zweiten Quelle für elektromagnetische Wechselfelder verbunden. Der zweite Koaxial-Außenleiter umgibt den Koaxial-Innenleiter und den ersten Koaxial Außenleiter im Bereich einer Prozesskammerdurchführung und endet dann abrupt, um einen Impedanzsprung für eine Plasmazündung vorzusehen.

Die DE 10 2004 039 468 A1 zeigt eine Vorrichtung zur Erzeugung ionisierter Teilchen in einem Plasma. Die Vorrichtung weist einen Koaxial-Innenleiter und einen Koaxial-Außenleiter auf, der den Koaxial-Innenleiter außerhalb und im Bereich einer Prozesskammerdurchführung umgibt und dann abrupt endet. Am Ende des KoaxialInnenleiters kann dieser eine gekrümmte Form aufweisen, um bei bestimmten Bedingungen eine Plasmazündung zu fördern.

Die DE 10 2006 048 814 A1 zeigt eine Vorrichtung und ein Verfahren zur Erzeugung von Mikrowellenplasmen Mittels eines Koaxialresonators bestehend aus Innenleiter, Außenleiter und Koppelstellen. Die Koppelstellen sind als rechteckige Öffnungen im Außenleiter vorgesehen.

Die DE 41 36 297 A1 zeigt eine Vorrichtung zur lokalen Erzeugung eines Plasmas in einer Behandlungskammer. Die Vorrichtung weist einen Innenleiter aus elektrisch leitendem Material und einen diesen vollständig umgebenden Führungsholleiter aus dielektrischem Material auf. Im Bereich einer Behandlungskammerdurchführung ist eine Metallummantelung vorgesehen, die als Wellenleiter dient, um zu verhindern, dass schon außerhalb der Behandlungskammer ein Plasma gezündet wird. Die Ummantelung endet abrupt beim Übergang in die Behandlungskammer.

Aufgabe der Erfindung ist es daher, eine Vorrichtung bereitzustellen, die ein Mikrowellenplasma mit einer sehr hoher Dichte an niederenergetischen Ionen und Elektronen erzeugt, so daß das mit einer dielektrischen Schicht, wie beispielsweise mit einer Oxidschicht zu versehende Substrat eine starke negative Aufladung seiner Oberfläche erhält. Auf diese Weise wird es möglich, bereits bei niedrigen Temperaturen unterhalb von 800 Grad Celsius innerhalb kurzer Zeit hinreichend dicke dielektrische Schichten, wie beispielsweise Oxidschichten auf einem Substrat, vorzugsweise einem Halbleitersubstrat zu bilden. Weitere Aufgabe der Erfindung ist es, ein Verfahren zur Erzeugung fehlerfreier und möglichst homogener dielektrischer Schichten in einem Mikrowellenplasma vorzugsweise bei niedrigen Temperaturen bereitzustellen.

Diese Aufgabe löst die Erfindung durch eine Vorrichtung nach Anspruch 1 oder 7 und durch ein Verfahren nach Anspruch 13. Weitere Ausführungsformen sind in den jeweiligen Unteransprüchen offenbart.

Die erfinderische Mikrowellenplasmavorrichtung, umfaßt unter anderem wenigstens eine Elektrode, die mit wenigstens einem Mikrowellengenerator verbunden werden kann, wobei die wenigstens eine Elektrode einen koaxialen Innenleiter aus elektrisch leitendem Material, sowie einen diesen zumindest teilweise umgebenden und von ihm beabstandeten koaxialen Außenleiter aus elektrisch leitendem Material aufweist. Die wenigstens eine Elektrode kann vorzugsweise eine Plasmazündvorrichtung aufweisen, die mit dem koaxialen Innenleiter, vorzugsweise mit dem Ende des koaxialen Innenleiters verbunden ist. Der koaxiale Außenleiter weist wenigstens einen ersten Teilbereich auf, in welchem er den koaxialen Innenleiter entlang dessen Längsachse vollständig umgibt, und wenigstens einen weiteren Teilbereich, in welchem er den koaxialen Innenleiter teilweise so umgibt, daß eine vom Mikrowellengenerator erzeugte Mikrowellenstrahlung in diesem wenigstens einen weiteren Teilbereich senkrecht zur Längsachse des koaxialen Innenleiters austreten kann. Der koaxiale Innenleiter kann beispielsweise rohrförmig ausgeführt sein. In diesem weiteren Teilbereich ist der koaxiale Außenleiter längs des koaxialen Innenleiters geöffnet, das heißt, der koaxiale Innenleiter ist in diesem Bereich nicht vollständig vom koaxialen Außenleiter umgeben, bzw. ummantelt. Jede Elektrode ist vorteilhafterweise mit einem Mikrowellengenerator elektrisch verbunden. Dem weiteren Teilbereich kann sich ein zusätzlicher Teilbereich anschließen, der dadurch gekennzeichnet ist, daß der koaxiale Innenleiter in diesem zusätzlichen Teilbereich nicht vom koaxialen Außenleiter umgeben ist. Dieser zusätzliche Teilbereich kann sich auch direkt an den wenigstens einen ersten Teilbereich anschließen, und/oder den wenigstens einen weiteren Teilbereich ersetzen. Ein Vorteil dieser Ausführung besteht darin, daß eine mit der erfinderischen Mikrowellenplasmavorrichtung betriebene Vorrichtung zum Behandeln von Halbleitersubstraten leicht auf Substratdurchmesser von 450 mm und mehr skaliert werden kann.

Die wenigstens eine Elektrode ist zumindest entlang des Teilbereichs, in welchem der Außenkoaxialleiter geöffnet ist, entlang der Längsachse des jeweiligen koaxialen

Innenleiters vorteilhafterweise von einem nicht leitenden Material umgeben. Dieses Material kann beispielsweise Quarzglas, Aluminiumoxid oder Saphir sein. Es ist vorteilhafterweise als Hohlzylinder ausgebildet. Der Hohlzylinder kann die Elektrode aufnehmen, oder zumindest den Teilbereich der Elektrode aufnehmen, in welchem der Außenleiter entlang der Längsachse des koaxialen Innenleiters geöffnet ist. Besonders vorteilhafterweise umschließt das nicht leitende Material jedoch auch noch das Ende der Elektrode, welches nicht mit dem Mikrowellengenerator verbunden wird. Die Mikrowellenabstrahlleistung der wenigstens einen Elektrode kann, vorteilhafterweise steuerbar und/oder oder regelbar sein.

Zwischen dem nicht leitenden Material, das einen Teil der Elektrode umschließt und der Elektrode selbst kann ein Raum ausgebildet sein, in welchem sich Umgebungsluft bei Normaldruck befindet. In diesem Raum kann sich jedoch auch ein anderes Gas unter reduziertem Druck befinden. Der Raum kann beispielsweise ein Prozeßgas, wie Sauerstoff, Wasserstoff, Stickstoff, N2O, und/oder ein Edelgas, oder eine Mischung aus diesen Gasen aufweisen. Der Druck in diesem Raum kann zwischen Null Bar und mehreren Bar liegen. Der Raum kann jedoch auch mit einem flüssigen oder festen dielektrischen Material ausgefüllt sein. Der Druck in diesem Raum ist jedoch vorzugsweise so zu wählen, daß sich kein Plasma zwischen der Elektrode und dem sie umschließenden Isolatorrohr ausbildet.

Der koaxiale Außenleiter kann im wenigstens einen weiteren Teilbereich so ausgebildet sein, daß er am einen Ende dieses Teilbereichs den koaxialen Innenleiter vollständig umgibt, und sich vom einen Ende zum anderen Ende dieses Teilbereichs öffnet und stetig verjüngt. Er ist vorteilhafterweise derart gestaltet, dass er über dem Randbereich des Halbleitersubstrats geöffnet wird und sich zum gegenüberliegenden Rand des Halbleitersubstrats in seinem Querschnitt stetig verjüngt. Der koaxiale Außenleiter kann in dem wenigstens einen weiteren Teilbereich beispielsweise aber auch mehrere Öffnungen entlang der Längsachse des koaxialen Innenleiters aufweisen. Er kann elliptisch oder rautenförmig aufgeschnitten sein. Er kann den Innenleiter ummanteln, beispielsweise zylindrisch, und er kann mehrere geöffnete Teilbereiche entlang dieses Mantels aufweisen, die beispielsweise elliptisch, rautenförmig oder rechteckig ausgeschnitten sind. Der Mantel des Außenleiters kann jedoch auch schräg abgeschnitten sein, so dass er entlang der Längsachse des Innenleiters einen offenen Bereich aufweist, Der Mantel kann V-förmig aufgeschnitten sein, er kann einen oder mehrere V-förmige, rechteckige, oder U-förmige Einschnitte aufweisen. Er kann aber beispielsweise auch so aufgeschnitten sein, dass er sich längs des wenigstens einen weiteren Teilbereichs spiralenförmig um den Innenleiter windet.

Die Zündvorrichtung kann als Induktivität am Ende des inneren Koaxialleiters ausgebildet sein. Der innere Koaxialleiter kann zu diesem Zweck beispielsweise an seinem Ende eine gekrümmte Form aufweisen. Die Zündvorrichtung ist vorteilhafterweise als linearer Hertzscher Oszillator ausgebildet, wobei die Wellenlänge dieses linearen Hertzschen Oszillators gleich der halben Wellenlänge des Mikrowellengenerators entspricht, und / oder einem ganzzahligen Vielfachen davon. Der Mikrowellengenerator weist vorteilhafterweise eine Mikrowellenfrequenz von 2,45 GHz, 5,4 GHz, 915 MHz oder 13-14 GHz auf. Er kann aber auch jede andere Frequenz aufweisen.

Die Mikrowellenplasmavorrichtung kann Bestandteil einer Vorrichtung zur Plasmabehandlung von Halbleitersubstraten beispielsweise in der Halbleiterprozeßtechnologie sein. Die Mikrowellenplasmavorrichtung kann beispielsweise einen von einem Metallkasten umschlossenen Prozeßraum aufweisen, wobei der Metallkasten eine verschließbare Öffnung zum Einführen des Halbleitersubstrats aufweist, wobei Mittel zum Kühlen und / oder Heizen des Metallkastens vorgesehen sein können. Sie kann einen im Prozeßraum angeordneten Substrathalter zur Aufnahme des Halbleitersubstrats beinhalten, und sie weist vorzugsweise wenigstens ein im Prozeßraum angeordnetes Isolatorrohr auf, welches vorteilhafterweise gegenüber dem Prozeßraum vakuumdicht abgeschlossen ist und in welchem wenigstens der Teil der wenigstens einen Elektrode eingeführt ist, der den geöffneten Koaxialaußenleiter aufweist. Weiterhin weist der Metallkasten wenigstens eine, vorzugsweise jedoch mehrere Öffnungen zum Einleiten von Prozeßgas auf, sowie wenigstens eine, vorzugsweise jedoch mehrere weitere Öffnungen zum Ausleiten des Prozeßgases auf. Die Öffnungen zum Ausleiten des Prozeßgases sind vorzugsweise mit einer Vakuumpumpe fest verbunden. Der Prozeßgasdruck im Prozeßraum ist vorzugsweise im Bereich zwischen einem Millitorr und 20 Torr einstellbar und/oder regelbar. Der Metallkasten kann beispielsweise aus Aluminium bestehen.

Der Substrathalter ist vorzugsweise um wenigstens eine Achse, die vorteilhafterweise senkrecht zur Halbleitersubstratoberfläche eines im Substrataufnahmebereich des Substrathalters aufgenommenen Halbleitersubstrats ist, drehbar im Prozeßraum angeordnet. Der Abstand zwischen dem Substrathalter und dem wenigstens einen Isolatorrohr kann veränderbar sein, so daß während eines Prozesses ein gewünschter Abstand zwischen dem Substrat und den Mikrowellenenergie abstrahlen-den Elektroden eingestellt werden kann. Der Substrathalter kann kühlbar und/oder heizbar sein. Er kann wenigstens teilweise aus entweder Aluminiumnitrid, und/oder Siliziumnitrid, und/oder Quarz, und/oder Saphir und/oder Siliziumkarbid bestehen. Bei runden Substraten, wie beispielsweise Halbleiterwafern kann der Substrataufnahmebereich von einem zusätzlichen ringförmigen Bereich umgeben sein, welcher einen ringförmig um den Substrataufnahmebereich angeordneten sogenannten erweiterten Substratbereich aufweist, welcher ringförmig um das Substrat angeordnete Elemente aus Substratmaterial beinhalten kann. Der Substrataufnahmebereich kann einen Suszeptor zur Aufnahme des Halbleitersubstrats aufweisen, wobei der Suszeptor beispielsweise mit wenigstens einem Thermoelement zur Messung der Temperatur des Substrates verbunden sein kann.

Es kann auch wenigstens eine Temperaturmeßvorrichtung zur Messung der Temperatur eines im Substrataufnahmebereich des Substrathalters aufgenommenen Halbleitersubstrats vorgesehen sein. Eine solche Temperaturmessung kann beispielsweise pyrometrisch erfolgen.

Der Prozeßraum weist zumindest eine Elektrode, vorteilhafterweise jedoch ein oder mehrere zueinander im wesentlichen parallel in einer Ebene oberhalb und / oder in einer Ebene unterhalb des Substrataufnahmebereiches angeordnete Isolatorrohre auf, wobei jedes Isolatorrohr vorzugsweise eine Elektrode umschließen kann, welche zumindest jedoch den wenigstens einen weiteren Teilbereich der jeweils wenigstens einen Elektrode umschließt, welcher den für den Austritt der Mikrowellenstrahlung vorgesehenen Teilbereich des Koaxialleiters, also zumindest den Teilbereich, in welchem der äußere Koaxialleiter entlang der Längsachse des koaxialen Innenleiters geöffnet ist, aufweist. Der innere Koaxialleiter kann jedoch beispielsweise zusätzlich oder anstatt des wenigstens einen weiteren Teilbereichs in seinem Endbereich auch einen Mikrowelle abstrahlenden zusätzlichen Teilbereich aufweisen, welcher nicht von einem äußeren Koaxialleiter umgeben ist. In diesem Fall umschließt das Isolatorrohr vorzugsweise auch diesen zusätzlichen Teilbereich der Elektrode.

Der koaxiale Außenleiter der wenigstens einen Elektrode ist vorteilhafterweise über dem Randbereich eines sich im Substrataufnahmebereichs des Substrathalters befindenden Halbleitersubstrats, und besonders vorteilhafterweise über dem gesamten erweiterten Substratbereich geöffnet. Weist die Vorrichtung mehrere Elektroden auf, so sind diese Elektroden, zumindest jedoch Teile der die elektromagnetische Energie abstrahlenden Bereiche dieser Elektroden vorzugsweise jeweils einzeln in Isolatorrohren untergebracht. Die Isolatorrohre sind vorzugsweise im wesentlichen parallel zueinander angeordnet, wobei "im wesentlichen parallel zueinander" bedeuten soll, daß die Längsachsen der Isolatorrohre zueinander einen Winkel von weniger als 10 Grad einschließen. Die oberhalb des Substrataufnahmebereichs im Prozeßraum angeordneten Isolatorrohre sind vorzugsweise alle in der gleichen Ebene angeordnet. Sind mehrere Isolatorrohre unterhalb des Substrataufnahmebereichs im Prozeßraum angeordnet, so sind diese ebenfalls vorzugsweise in einer Ebene angeordnet. Die abstrahlenden Bereiche der in den Isolatorrohren untergebrachten Elektroden überdecken besonders vorteilhafterweise den gesamten Substrataufnahmebereich, vorzugsweise auch noch den erweiterten Substratbereich. Die Mikrowellenabstrahlleistung der Elektroden kann, sofern die Vorrichtung mehrere Elektroden aufweist, vorteilhafterweise für jede Elektrode einzeln und/oder für eine vorgegebene Anzahl von Elektroden, die zu einer Gruppe zusammengefaßt werden, gruppenweise entweder gesteuert oder geregelt, oder gesteuert und geregelt werden. Vorteilhafterweise können, um die Homogenität des Plasmas zu erhöhen, einander benachbarte Elektroden auf einander gegenüberliegenden Seiten des jeweiligen Isolatorrohrs mit der jeweiligen Mikrowellenquelle verbunden sein. Die Elektroden können einzeln oder gruppenweise mit unterschiedlichen Mikrowellenquellen verbunden sein, wobei die unterschiedlichen Mikrowellenquellen mit gleichen, oder vorteilhafterweise mit unterschiedlichen Abstrahlfrequenzen Mikrowellenenergie abstrahlen können.

Unterhalb und / oder oberhalb des Substrataufnahmebereichs können zusätzliche Heizelemente im Prozeßraum angeordnet sein. Diese Heizelemente können beispielsweise Halogenlampen und / oder Bogenlampen sein. Sie können vom Prozeßraum durch Quarzglas und / oder einem mit Fremdatomen dotiertem Quarzglas, und / oder Quarzglas, welches einen mit Fremdatomen dotierten Bereich aufweist, getrennt sein.

An der Oberseite des Metallkastens kann eine Isolatorplatte so angeordnet sein, dass ein Kontakt des Plasmas mit der Metallwand verhindert wird. Der Metallkasten kann beispielsweise auf seiner dem Prozeßraum zugewandten Seite Oberflächenbereiche aus anodisiertem Aluminium aufweisen. Der Prozeßraum kann weiterhin eine vom Metallkasten beabstandete Elektrode oberhalb und / oder unterhalb des Substrataufnahmebereichs aufweisen, wobei vorteilhafterweise die beabstandete Elektrode mit der Isolatorplatte fest verbunden ist. Diese beabstandete Elektrode kann beispielsweise mit einer Gleichspannung oder mit einer gepulsten Gleichspannung beaufschlagt werden, um eine anodisierte Oxidation durchzuführen. Sie kann auch mit einer Wechselspannung beaufschlagt werden. Wechselspannung ist geeignet, das Plasma und / oder die Oberflächenladung des zu behandelnden Substrats, beispielsweise des Halbleiterwafers zu modulieren und kann auf diese Weise zu einer Verbesserung der Prozeßergebnisse beitragen. Es ist in diesem Zusammenhang auch möglich, diese Elektrode nur zeitweise, z. B. gepulst mit einer Gleichspannung zu beaufschlagen, während der Plasmaprozeß stattfindet. Auch ist es möglich, den Plasmaprozeß selbst gepulst und / oder zeitlich moduliert durchzuführen. Der Fachmann wird Ausgestaltungen und Kombinationen dieser Möglichkeiten in Betracht ziehen, um gewünschte Prozeßergebnisse zu erreichen.

Die Behandlung eines Halbleitersubstrats in einer solchen Vorrichtung weist vorzugsweise folgende Schritte auf:
a) Einführen des Halbleitersubstrats in den Prozeßraum und Ablage des Halbleitersubstrats auf dem im Prozeßraum angeordneten Substrathalter
b) Abpumpen des Prozeßraums
c) Einleiten von Prozeßgas in den Prozeßraum
d) Einleitung von Mikrowellenstrahlung über die Elektrode / die Elektroden der Mikrowellenplasmavorrichtung in den Prozeßraum und Erzeugen eines Mikrowellenplasmas im Prozeßraum
e) Abschalten der Mikrowellenstrahlung
f) Belüften des Prozeßraums, bzw. der Prozeßkammer
g) Herausnehmen des Halbleitersubstrats aus dem Prozeßraum

Zwischen Schritt a) und Schritt g) kann das Halbleitersubstrat dabei vor und/oder während und/oder nach Schritt d) des Prozesses vorteilhafterweise auf eine vorbestimmte Temperatur aufgeheizt werden. Diese vorbestimmte Temperatur liegt vorzugsweise zwischen Raumtemperatur und 650 Grad Celsius.

Das Prozeßgas kann beispielsweise Argon, Helium, Sauerstoff, Wasserstoff, Stickstoff, H2O (Wasserdampf), Deuterium, D2O (schweres Wasser in Dampfform) und oder Distickstoffoxid aufweisen, jedoch auch eine Mischung aus diesen Gasen. Es kann jedoch beispielsweise auch NF3, CF4 oder Cl2 aufweisen oder eine Mischung aus diesen Gasen. Dies kann bei Reinigungsvorgängen vorteilhaft sein.

Mit der erfinderischen Vorrichtung können auch fehlerfreie dielektrische Schichten erzeugt werden. Die negative Aufladung der Substratoberfläche ist dabei die treibende Kraft bei der Erzeugung einer fehlerfreien dielektrischen Schicht, da der Schichtaufbau an allen Bereichen der Oberfläche so lange fortgeführt wird, bis eine der Ladung äquivalente Schichtdicke erreicht ist.

Vorteile des erfinderischen Verfahrens bei der Oxidation beispielsweise liegen darin, dass im Gegensatz zur thermischen Oxidation, welche, aufgrund der erforderlichen hohen Temperatur diffusionskontrolliert ist, hier ein Verfahren zum Oxidieren zum Einsatz kommt, das aufgrund des elektrischen Feldes, das durch die Oberflächenladung erzeugt wird, zu einer Oxidschichtbildung führt. Bei CVD- und ALD Verfahren sind hingegen maßgeblich die jeweiligen chemischen Potentiale der Substratoberflächen für ein fehlerfreies Schichtwachstum erforderlich, welche schwierig zu kontrollieren sind.

Da die Oxidation durch das elektrische Feld der durch das Mikrowellenplasma erzeugten negativen Aufladung verursacht wird, kann nun die Oxidation bereits bei Zimmertemperatur oder leicht erhöhter Temperatur durchgeführt werden. Die Oxidation ist unabhängig von der Substrattemperatur und es kann die Substrattemperatur nun so eingestellt werden, dass optimale Prozessergebnisse erzielt werden. Des weiteren ist die Oxidation auch unabhängig von der Dotierstoffspezies und der Dotierstoffkonzentration im Silizium. Mit dem erfinderischen Verfahren ist es möglich, auch Silizumnitrid gut bei Zimmertemperatur zu oxidieren. Die Zugabe von Wasserstoff hat auf das Wachstum der Oxidschicht bis ein in den hohen Prozentbereich von 'Wasserstoff im Prozeßgas kaum merklichen Einfluss auf die Oxidschichtdicke, was eine selektive Oxidation von Silizium zu Metallen und Metallnitriden ermöglicht.

Neben der Oxidation von Silizium ist auch die Oxidation von Tantal, Niob, Aluminium und deren Nitriden möglich. Durch die Oxidation der Metalle bzw. deren Nitride können, im Gegensatz zu CVD und ALD-Verfahren, bei Zimmertemperatur fehlerfreie hochwertige dielektrische Schichten für beipielsweise MIM-Capacitors abgeschieden werden, die für "RF" und "DECOUPLING"-Anwendungen, sowie für eine Vielzahl von Automotive, Communication und andere Logik-Geschäftsgebieten Anwendung finden.

Die erfinderische Vorrichtung und das erfinderische Verfahren ermöglicht die Erzeugung eines Mikrowellenplasmas mit einer sehr hoher Dichte an niederenergetischen Ionen und Elektronen, wobei bekanntlich der Ionisationsgrad des anzuregenden Gases mit dem Quadrat der Anregungsfrequenz zunimmt. Beim Mikrowellenplasma ist bei einer Anregungsfrequenz von beispielsweise 2,45 GHz ein Ionisationsgrad von ca. 80% erreichbar, wenn die eingestrahlte Leistung zur Sättigung des Plasmas ausreicht. Wegen des Unterschieds der Massen der Elektronen zu den positiv geladenen Ionen von ca. 4 Zehnerpotenzen und des geringen Stoßquerschnitts der niederenergetischen Elektronen ist die mittlere freie Weglänge der Elektronen im Plasma um bis zu 2 Zehnerpotenzen größer als die der Ionen. In der Grenzzone des Plasmas zum Substrat erreichen dadurch die Elektronen die Oberfläche des Substrats viel schneller und es entsteht eine starke negative Aufladung auf dem Substrat. Die Aufladung kommt erst dann zum Stillstand wenn genügend positive Ionen aus dem Plasma angezogen werden. Ein Teil der positiven Ionen, im vorliegenden Fall beispielsweise im wesentlichen ein Teil der einfach positiv geladenen Sauerstoffionen, d.h. der durch das Plasma erzeugte, einfach positiv geladene Sauerstoff wird neutralisiert und kehrt in den Plasmaraum zurück. Ein anderer Teil der einfach positiv geladenen Sauerstoffionen nimmt jeweils 2 oder 3 Elektronen auf und wird dadurch einfach oder zweifach negativ geladen. Dieser Teil wird nun durch die negative Oberflächenladung auf dem Substrat vom Substrat abgestoßen. Ein Teil des negativ geladenen Sauerstoffs wird ebenfalls in den Plasmaraum zurück transportiert. Ein anderer Teil des negativ geladenen Sauerstoffs kann, wenn er die negative Ladungszone des Plasmas durchstoßen hat, zur Oxidation des Substrats und zum Aufbau des Dielektrikums beitragen.

Die erfindungsgemäße Vorrichtung und das erfindungsgemäße Verfahren werden nachfolgend anhand bevorzugter Ausführungsbeispiele unter Bezugnahme auf die Zeichnungen näher erläutert. Dabei sind gleich wirkende Elemente in unterschiedlichen Figuren mit den gleichen Zahlen gekennzeichnet. Dem Fachmann sind jedoch Ausgestaltungen und Abwandlungen der Beispiele, sowie Kombinationen der offenbarten Ausführungsformen möglich, ohne daß dadurch der Erfindungsgedanke verlassen wird. Die erfindungsgemäße Vorrichtung ist insbesondere auch im Zusammenhang mit anderen Einsatzgebieten oder Verfahren, als den hier beschriebenen, mit Vorteil einsetzbar.

### In den Zeichnungen zeigen:

Die Figuren 1, 1a, 1b, 2, 3 verschiedene Ausgestaltungen der erfindungsgemäßen Vorrichtung,

Die Figur 4 verschiedene Ausführungsformen 4a, 4b, 4c des koaxialen Außenleiters und 4d, 4e, 4f, 4g verschiedene Ausführungsformen des koaxialen Innenleiters der Elektrode

Die Figuren 5, 6, 7 und 8 Oxidationsergebnisse verschiedener auf Halbleitersubstraten mit Hilfe der erfinderischen Vorrichtung aufgebrachten Oxide

Die Figur 9 ein Beispiel für ein fehlerhaftes Dielektrikum auf einem Substrat, welches mittels anodischer Oxidation im Plasma repariert wurde.

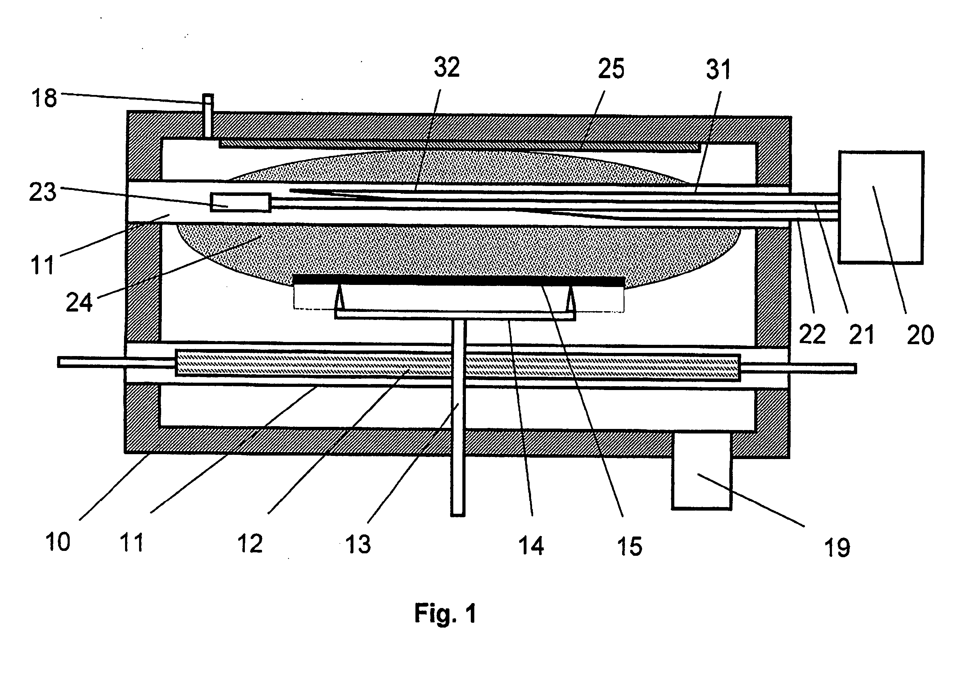

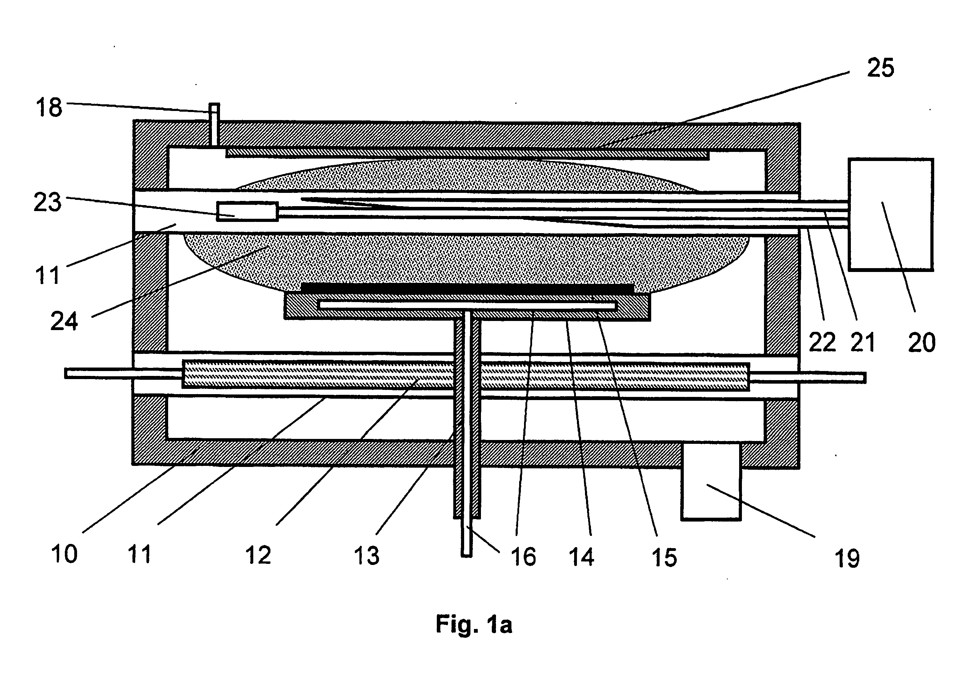

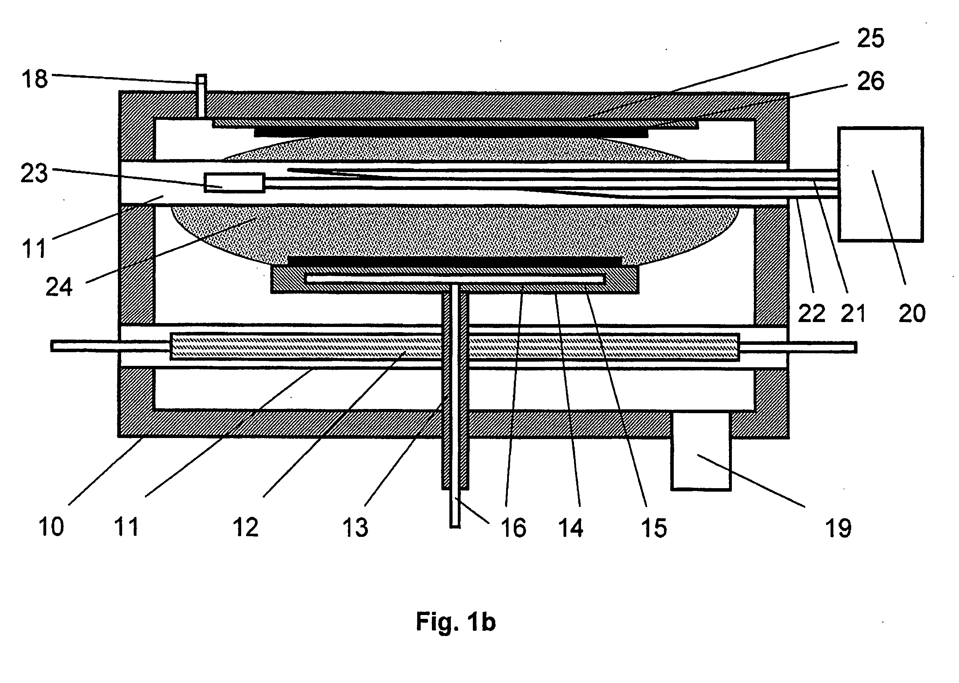

Die Figuren 1, 1 a und 1b stellen einen Querschnitt der erfinderischen Vorrichtung dar. Sie zeigen einen Metallkasten 10, welcher eine beispielsweise mit einer Tür verschließbare Öffnung (nicht eingezeichnet) aufweist, und einen Prozeßraum umschließt. Der Metallkasten 10 ist mit Isolatorrohren 11 verbunden. Die Isolatorrohre 11 sind vorzugsweise auf einander gegenüberliegenden Seiten des Metallkastens 10 über vorzugsweise den Prozeßinnenraum gegen die Umgebungsatmosphäre hermetisch abdichtende Dichtungen mit dem Metallkasten 10 verbunden und erstrecken sich durch den gesamten Prozeßraum. Die Isolatorrohre 11 bestehen vorzugsweise aus Quarz oder Aluminiumoxid. Die Dichtungen sind vorzugsweise so ausgeführt, daß, wenn der Prozeßraum abgepumpt ist, keine Umgebungsatmosphäre durch diese Dichtungen in den Prozeßraum eindringen kann. Ein Teil der Isolatorrohre 11 kann beispielsweise Heizelemente 12, wie beispielsweise Halogenlampen oder Bogenlampen aufweisen. Wie in Figur 1 dargestellt ist, kann ein vorzugsweise drehbar mit einem Antrieb versehener und um die Antriebsachse 13 rotierender und axial verschiebbarer im Prozeßraum angeordneter Substrathalter 14 zum Halten des Substrats 15 auf beispielsweise Pins in einem Substrataufnahmebereich in der Prozeßkammer vorgesehen sein. Im Prozeßraum angeordnet kann jedoch auch ein eine Kühl- und/oder Heizflüssigkeit 16 aufweisender Substrathalter 14 angeordnet sein, wie dies beispielsweise in den Figuren 1a und 1b dargestellt ist. In diesem Fall kann das Substrat 15 flächig auf dem Substrathalter 14 angeordnet sein, um einen möglichst guten thermischen Kontakt zum Substrathalter zu gewährleisten. Die Heizelemente 12 (Halogenstrahler, Gasentladungslampen etc.) zur möglichen Erwärmung des Suszeptors bzw. Substrats auf eine gewünschte Prozesstemperatur sind unterhalb des zu bearbeitenden Substrats 15 angebracht. Der Metallkasten weist wenigstens einen, vorzugsweise jedoch mehrere Gaseinlässe 18 für den Einlaß von Prozeßgas, sowie wenigstens einen Gasauslaß 19, der vorzugsweise mit einer Vakuumpumpe verbunden ist, auf. Die oberhalb des Substrataufnahmebereichs angeordneten Isolatorrohre 11 beinhalten die mit wenigstens einem Mikrowellengenerator 20 verbundenen Elektroden 21, 22, 23. Die Elektroden 21, 22, 23 weisen einen dünnen, rohrförmigen koaxialen Innenleiter 21 aus elektrisch leitendem Material, sowie einen diesen zumindest teilweise umgebenden und von ihm beabstandeten koaxialen Außenleiter 22 aus elektrisch leitendem Material auf, sowie eine Plasmazündvorrichtung 23, die mit dem koaxialen Innenleiter 21 verbunden ist. Das Mikrowellenplasma 24 entsteht außerhalb des Isolatorrohres 11 im Prozeßraum. Die Isolatorrohre 11 bestehen vorzugsweise aus Quarzglas und weisen in ihrem Innenraum beipielsweise Luft unter Normaldruck auf. Der obere Teil des Metallkastens 10 kann, wie dies in den Figuren 1, 1 a und 1b dargestellt ist, vorteilhafterweise mit einem isolierenden Material 25 versehen sein, um zu verhindern, daß das Plasma 24 Metallkontaminationen auf dem Halbleitersubstrat 15 verursacht. Figur 1b zeigt eine Ausführungsform, bei der eine Elektrode 26 mit dem isolierenden Material 25 fest verbunden ist. Mittels dieser Elektrode 26 kann eine zusätzliche Spannung zwischen Halbleitersubstrat und Elektrode angelegt werden und eine anodische Oxidation durchgeführt werden. Dies hat den Vorteil, daß dickere Schichten erzeugt werden können. Der koaxiale Außenleiter 22 der Elektrode 21, 22, 23 weist wenigstens einen ersten Teilbereich 31 auf, in welchem er den koaxialen Innenleiter 21 entlang dessen Längsachse vollständig umschließt. Er weist darüber hinaus wenigstens einen weiteren Teilbereich 32 auf, in welchem er den koaxialen Innenleiter 21 teilweise so umschließt, daß eine vom Mikrowellengenerator 20 erzeugte Mikrowellenstrahlung in dem wenigstens einen weiteren Teilbereich 32 im Wesentlichen senkrecht zur Längsachse des koaxialen Innenleiters 21 austreten kann, sofern die Elektrode 21, 22, 23 mit dem Mikrowellengenerator 20 verbunden ist.

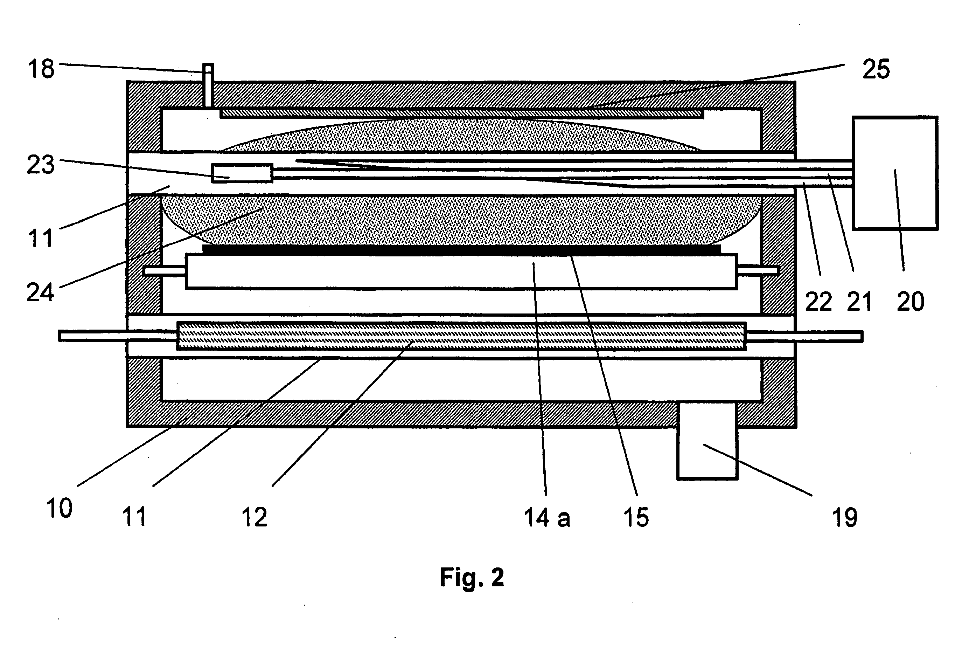

Figur 2 zeigt eine weitere Ausführungsform der erfinderischen Vorrichtung. Hier ist im Vergleich zu den Ausführungsformen in den Figuren 1, 1a und 1b der Suszeptor 14 durch eine Transportrolle 14a, die das Halbleitersubstrat 15 durch den Metallkasten transportiert, ersetzt.

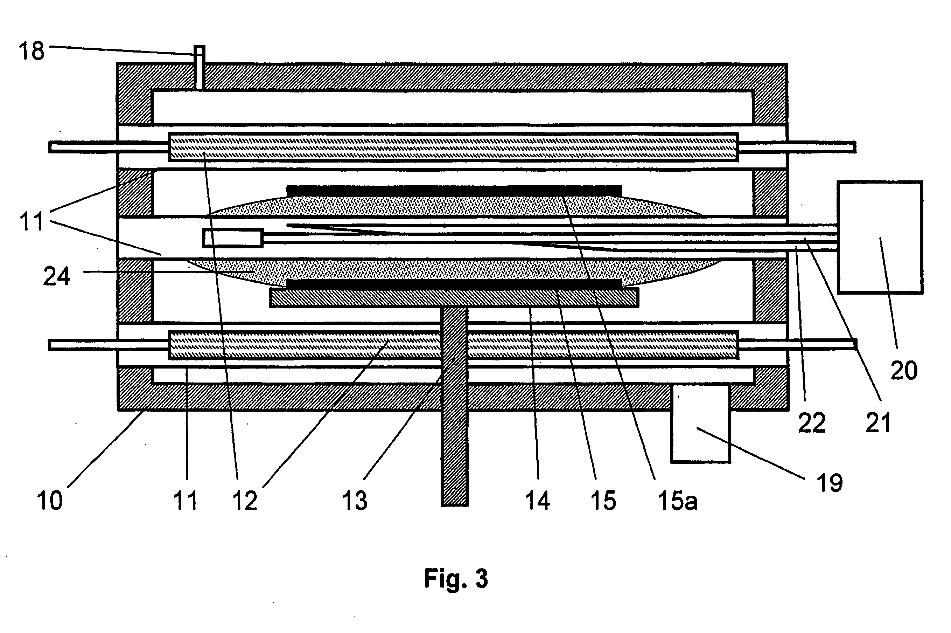

Figur 3 zeigt eine weitere Ausführungsform der erfinderischen Vorrichtung. Hier befinden sich die Elektroden 21, 22 für die Erzeugung des Mikrowellenplasmas zwischen einem Halbleitersubstrat 15 und einem weiteren Halbleitersubstrat 15a im Prozeßraum. Die Heizelemente 12 sind jeweils oberhalb beider Halbleitersubstrate und unterhalb beider Halbleitersubstrate im Prozeßraum angeordnet.

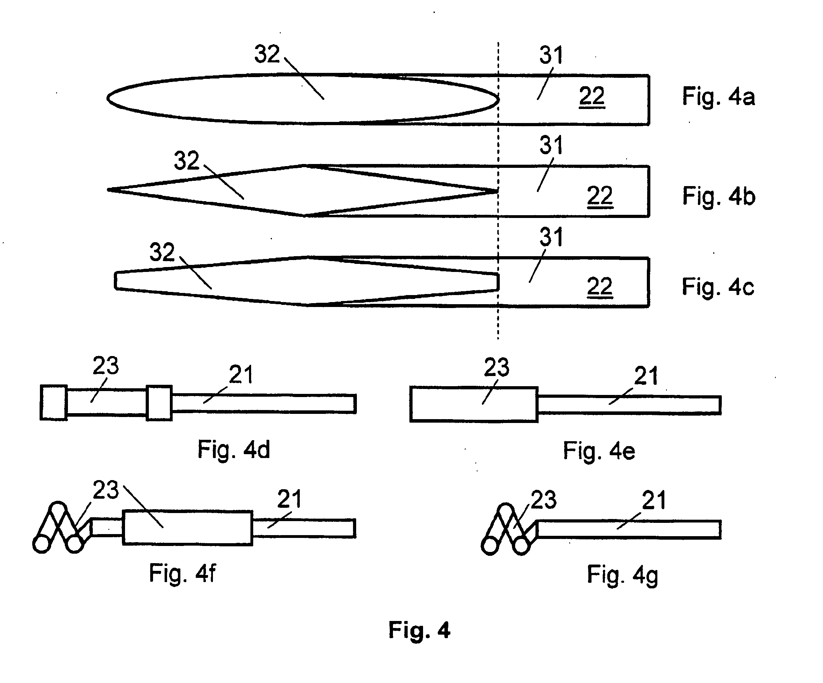

Verschiedene Ausführungsformen des Koaxialaußenleiters sind in den Figuren 4a, 4b und 4c beschrieben. Dargestellt in den Figuren 4a, 4b und 4c sind die ersten Teilbereiche 31, in welchen der koaxiale Außenleiter 22 den koaxialen Innenleiter vollständig umschließt, sowie die weiteren Teilbereiche 32, in welchen der koaxiale Außenleiter 22 den koaxialen Innenleiter teilweise umschließt. Figur 4a zeigt einen elliptisch aufgeschnittenen Koaxialaußenleiter. Figur 4b zeigt einen rautenförmig aufgeschnittenen koaxialen Außenleiter und Figur 4c zeigt einen sechseckig aufgeschnittenen Koaxialaußenleiter. Diese Gestaltungen des koaxialen Außenleiters sind vorteilhaft, da die elektomagnetische Welle zwischen dem Innen- und Außenleiter transportiert wird und durch die Öffnung 32 des Außenleiters 22 austreten kann, um die Plasmawolke 24 zu erzeugen. Es entsteht dadurch eine Begrenzung der Plasmawolke 24 in axialer Richtung und es wird verhindert, dass sich das Plasma bis zu den Einlassungen des Isolatorrohrs 11 in den Metallkasten 10 (siehe z.B. Figur 1) ausbreitet und Metallkontamination verursacht. Außerdem wird durch diese vorteilhafte Gestaltung des Außenleiters 22 verhindert, dass die elektrische Leitfähigkeit des Substrats und sein Abstand zu den Elektroden einen Einfluß auf die Ausbildung der Plasmawolke ausüben kann.

Die Figuren 4d, 4e, 4f und 4g zeigen vorteilhafte Ausführungsformen der vorzugsweise am Ende des koaxialen Innenleiters 21 angebrachten Plasmazündvorrichtungen 23. Die Zündvorrichtung 23 der MW-Plasmavorrichtung ermöglicht zuverlässiges Zündverhalten sowohl bei niedrigem als auch bei hohem Druck in der Vorrichtung und kann als linearer Hertzscher Oszillator mit der halben Wellenlänge bzw. einem vielfaches der halben Wellenlänge der Mikrowelle ausgebildet werden. Des weiteren kann die Zündvorrichtung 23 als Induktivität am Ende des Innenleiters 20 ausgebildet sein, wobei die Induktivität dann aus wenigen Windungen des Innenleiters gebildet wird.

### Die erfinderische Vorrichtung funktioniert folgendermaßen:

Das Mikrowellenplasma wird bei einem Unterdruck von ca. 1/10.000 bis 1/1000 des Atmosphärendrucks durch Einleiten von oxidierenden, neutralen und/oder reduzierenden Gasen in die Prozeßkammer und Anregung selbiger durch Mikrowellenenergie über einen Mikrowellengenerator 20, in der Regel bei 2,45GHz, erzeugt. Das zu behandelnde Substrat 15 wird über die Dreh- und Hubeinrichtung 13, und dem Substrathalter 14, 14a, zu den Elektroden 21, 22 des Mikrowellenkoaxialeiters in einem gewünschten Abstand (ca.1 cm bis 15 cm) gehalten und rotiert. Durch eine entsprechende Einstellung von Druck, Gaszusammensetzung, Mikrowellenleistung und Elektrodenabstand kann damit eine gewünschte Plasma- bzw. Ladungsdichte am Substrat erzeugt werden, wodurch die gewünschten Prozessergebnisse erzielt werden können. Zur Erzeugung eines Plasmas unabhängig von der Leitfähigkeit des Substrats, sowie des Abstands zu den Elektroden ist es notwendig, dass die zwischen dem Koaxial-Innenleiter 21 und dem Koaxialaußenleiter 22 eingeleitete Mikrowellenenergie gleichmäßig über eine Öffnung des koaxialen Außenleiters 22 austritt und die Mikrowellenenergie gleichmäßig in die Plasmazone eingeleitet wird, wo sie absorbiert wird. Dies wird durch eine entsprechende Gestaltung des Koaxialen Außenleiters 22, um den, oder entlang des koaxialen Innenleiters 21 mit dem entsprechenden Abschluss, bzw. mit der entsprechenden Zündvorrichtung erreicht. Eine Plasmaanregung nur über den Innenleiter, wie sie üblicherweise bei stabförmiger Plasmaanregung gebräuchlich ist, kann nicht verwendet werden, da die Mikrowelle sich über ein leitfähiges Substrat fortpflanzen kann und damit zu unkontrollierbaren Effekten führt. Ein Abschluss des Koaxialsinnenleiters 21 durch eine Plasmazündvorrichtung 23 ist vorgesehen, damit das Gas sowohl bei sehr geringen als auch besonders großen Drücken zuverlässig gezündet werden kann.

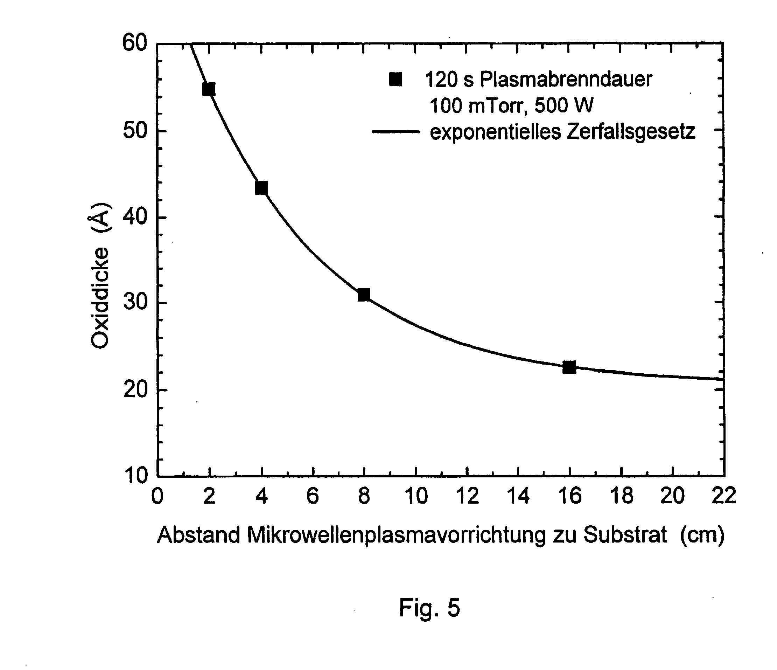

Figur 5 zeigt die auf einem Siliziumsubstrat aufgewachsene Oxiddicke in Abhängigkeit vom Abstand zwischen dem Substrat und der Mikrowellenplasmavorrichtung bei einer Plasmabrenndauer von 120 Sekunden, einem Prozeßgasdruck von 100 Millitorr und bei einer Mikrowellenabstrahlleistung von 500 Watt. Als Prozeßgas wurde Sauerstoff genommen. Die aufgewachsene Oxiddicke folgt einem Exponentialgesetz.

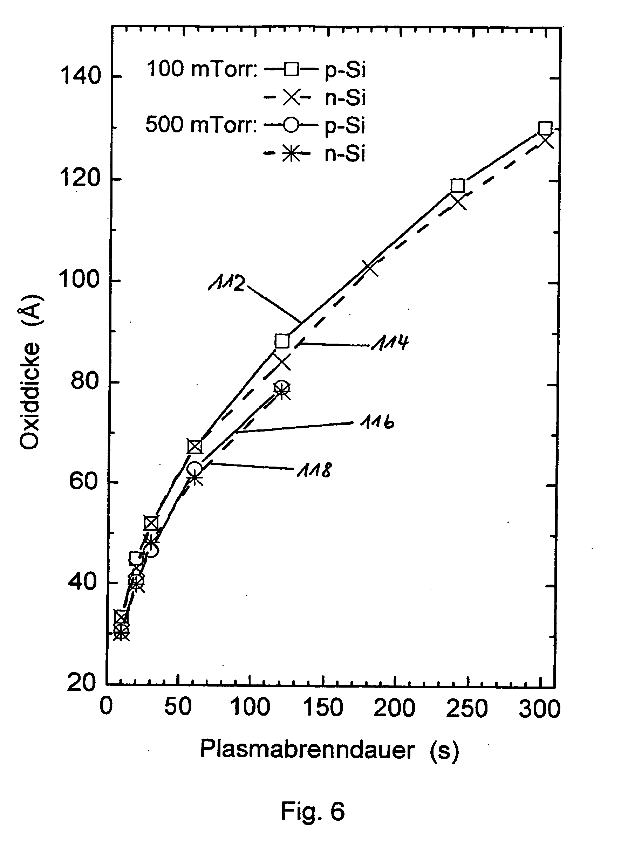

Figur 6 zeigt die Wachstumskurve des Plasmaoxids bei Raumtemperatur für unterschiedliche Substrate und unterschiedliche Prozeßgasdrücke in der erfinderischen Vorrichtung als Funktion der Brenndauer des Plasmas in Sekunden. Kurve 112 mit den quadratischen Symbolen zeigt die Oxiddicke von mit Bor dotiertem p-Silizium bei einem Prozeßgasdruck von 100 Millitorr Sauerstoff im Prozeßraum. Kurve 114 mit den Kreuz-Symbolen zeigt die Oxiddicke von mit Phosphor dotiertem n-Silizium bei einem Prozeßgasdruck von 100 Millitorr. Kurve 116 mit den runden Symbolen zeigt die Oxiddicke von mit Bor dotiertem p-Silizium bei einem Prozeßgasdruck von 500 Millitorr. Kurve 118 mit den sternförmigen Symbolen zeigt die Oxiddicke von mit Phosphor dotiertem n-Silizium bei einem Prozeßgasdruck von 500 Millitorr. Die Abbildung zeigt, daß das Siliziumdioxid Wachstum unabhängig von der Substratgrunddotierung ist. Dieses Beispiel zeigt, daß durch das erfindungsgemäße Verfahren ein Mikrowellenplasma mit einer sehr hohen Dichte an niederenergetischen Ionen und Elektronen erzeugt wird, das dazu führt, daß die Oxidation bei Temperaturen zwischen Raumtemperatur und 700 Grad Celsius sowohl zu einer orientierungsunabhängigen, als auch zu einer dotierungsunabhängigen und weitestgehend substratunabhängigen Oxidation von beispielsweise Silizium führt.

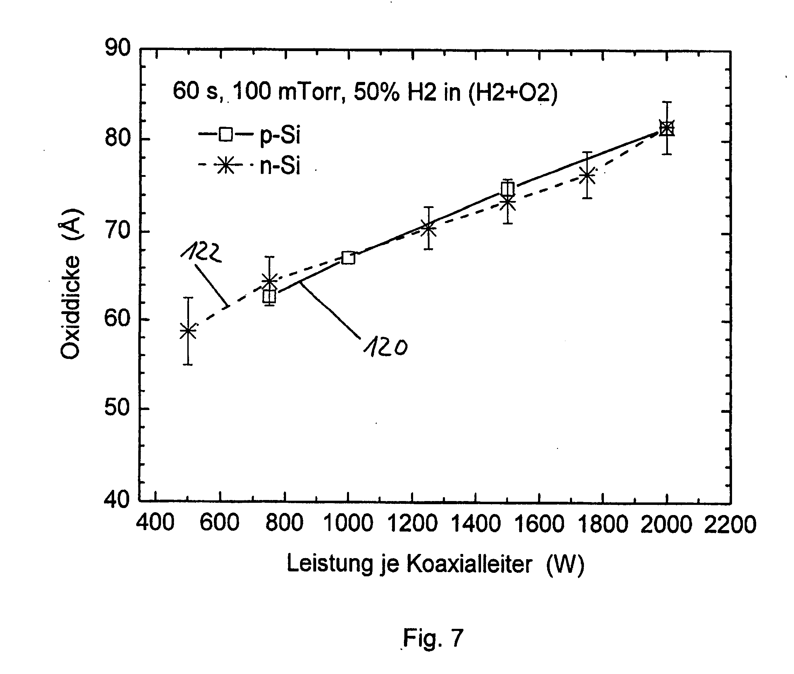

Figur 7 zeigt die gewachsene Oxiddicke in Angstrom in der erfindungsgemäßen Vorrichtung in Abhängigkeit von der Plasmaleistung pro Elektrode in Watt bei einer Plasmabrenndauer von 60 Sekunden, sowie einem Prozeßgasdruck von 100 Millitorr. Als Prozeßgas wurde eine Mischung aus 50% Wasserstoff in Wasserstoff und Sauerstoff genommen. Kurve 120 mit den quadratischen Symbolen zeigt die Oxiddicke von mit Bor dotiertem p-Silizium in Abhängigkeit von der Mikrowellenleistung, Kurve 122 mit den sternförmigen Symbolen zeigt die Oxiddicke von mit Phosphor dotiertem n-Silizium, sowie den möglichen Meßfehler bei jeder Messung. Diese Abbildung zeigt, daß das Oxidwachstum unabhängig von der Substratdotierung ist und stetig mit der Erhöhung der eingebrachten Plasmaleistung zunimmt.

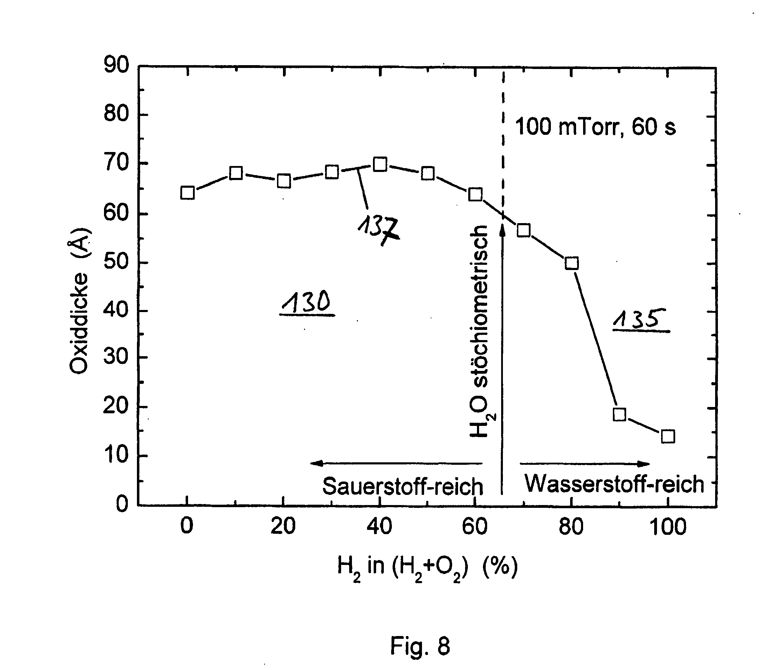

Figur 8 zeigt die Abhängigkeit der Oxiddicke von der Wasserstoffbeimischung zu Sauerstoff. Als sauerstoffreicher Bereich 130 wird ein Bereich definiert, in dem das Mischungsverhältnis von Wasserstoff zu Sauerstoff kleiner als 2:1 ist. Als wasserstoffreicher Bereich 135 wird ein Bereich definiert, in dem das Mischungsverhältnis von Wasserstoff zu Sauerstoff größer als 2:1 ist. Als stöchiometrisches Mischungsverhältnis von Wasserstoff zu Sauerstoff wird ein wird ein Mischungsverhältnis von 2 Teilen Wasserstoff auf 1 Teil Sauerstoff bezeichnet. Kurve 137 zeigt die Oxiddicke in Angstrom, die auf einer Siliziumscheibe innerhalb einer Plasmabrenndauer von 60 Sekunden aufwächst. Bis zu einer Beimischung von Wasserstoff im stoechiometrischen Mischungsverhältnis bleibt die Oxiddicke innerhalb des Meßfehlers konstant. Bei weiter erhöhter Wasserstoffkonzentration nimmt die Oxiddicke erwartungsgemäß ab. Dieses Beispiel zeigt den besonderen Vorteil des erfindungsgemäßen Verfahrens zwischen selektiver und nicht-selektiver Oxidation. Durch Wahl des Sauerstoff-Wasserstoff-Mischungsverhältnisses können beliebige Prozeßbedingungen bei Raumtemperatur eingestellt werden. Auf diese Weise kann beispielsweise bei der selektiven Oxidation das Abdampfen des Metalls weitestgehend vermieden werden, und es wird auf diese Weise eine selektive Oxidation von Silizium mit beispielsweise Wolfram, Niob, Tantal, Tantalnitrid, Titan, Titannitrid oder mit anderen Nitriden möglich, bei der das zu oxidierende Silizium nahezu die gleiche Oxidationsrate aufweist, wie dies der Fall bei einer nicht selektiven Oxidation von Silizium mit beispielsweise Wolfram, Niob, Tantal, Tantalnitrid, Titan, Titannitrid oder mit anderen Nitriden ist.

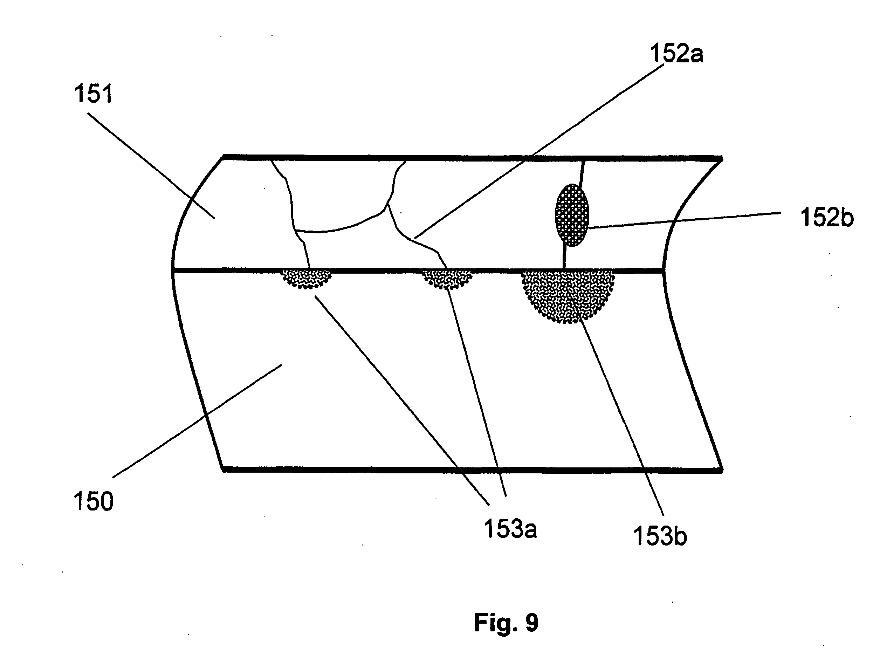

Figur 9 zeigt ein Substrat 150 aus Silizium, auf dem sich ein fehlerhaftes Dielektrikum 151 mit Fehlern 152a, 152b befindet, welches durch anodische Oxidation im Plasma mit SiO2 bzw. Ta2O5 Halbkugeln 153a, 153b repariert wurde. So können Durchbruchspannungen von bis zu 14 Volt realisiert werden. Die anodische Oxidation kann auch vorteilhaft bei anderen Substraten, wie beispielsweise Ta, TaN verwendet werden. Durch Anlegen von Gleichspannung an beispielsweise die Elektrode 26 kann die anodische Oxidation durchgeführt werden und dickere dielektrische Schichten können auf diese Weise auf dem Substrat erzeugt werden.

## Patentansprüche

1. Mikrowellenplasmavorrichtung, die folgendes aufweist:
wenigstens eine Elektrode (21, 22, 23), die ein mit einem Mikrowellengenerator (20) verbindbares Anschlussende und ein freies Ende besitzt, und
wenigstens eine Plasmazündvorrichtung (23),
wobei die wenigstens eine Elektrode (21, 22, 23) einen koaxialen Innenleiter (21) aus elektrisch leitendem Material, sowie einen diesen zumindest teilweise umgebenden und von ihm beabstandeten koaxialen Außenleiter (22) aus elektrisch leitendem Material aufweist,
wobei der koaxiale Außenleiter (22) in seiner Längsrichtung wenigstens einen ersten Teilbereich (31) aufweist, in welchem er den koaxialen Innenleiter (21) vollständig umschließt, und wobei die Plasmazündvorrichtung (23) mit dem koaxialen Innenleiter (21) verbunden ist;
**dadurch gekennzeichnet, dass** der koaxiale Außenleiter (12) daran anschließend wenigstens einen weiteren Teilbereich (32) aufweist, in dem der Außenleiter (22) so ausgebildet ist, dass er sich ausgehend vom ersten Teilbereich (31) zum freien Ende der wenigstens einen Elektrode hin stetig verjüngt, und dadurch den koaxialen Innenleiter (21) immer weniger umschließt, sodass eine vom Mikrowellengenerator (20) erzeugte Mikrowellenstrahlung in dem wenigstens einen weiteren Teilbereich (32) im Wesentlichen senkrecht zur Längsachse des koaxialen Innenleiters (21) austreten kann, wenn die wenigstens eine Elektrode (21, 22, 23) mit dem Mikrowellengenerator (20) verbunden ist.

2. Mikrowellenplasmavorrichtung nach Anspruch 1 , wobei die Plasmazündvorrichtung (23) mit dem freien Ende des koaxialen Innenleiters (21) verbunden ist.

3. Mikrowellenplasmavorrichtung nach einem der vorhergehenden Ansprüche, wobei wenigstens der eine weitere Teilbereich (32) entlang der Längsachse des koaxialen Innenleiters (21) von einem nicht leitenden Material (11) umgeben ist.

4. Mikrowellenplasmavorrichtung nach Anspruch 3, wobei das nicht leitende Material (11) Quarzglas, Aluminiumoxid oder Saphir ist, und/oder vorzugsweise als Hohlzylinder ausgebildet ist und/oder vorzugsweise ein Ende der Elektrode (21,22, 23) umschließt, wobei zwischen dem nicht leitenden Material und dem wenigstens einen weiteren Teilbereich (32) ein Raum ausgebildet ist, in dem sich vorzugsweise Umgebungsluft bei Normaldruck befindet.

5. Mikrowellenplasmavorrichtung nach einem der vorhergehenden Ansprüche, wobei der koaxiale Außenleiter in dem wenigstens einen weiteren Teilbereich (32) eine elliptische oder eine rautenförmige Öffnung (22a, 22b, 22c) aufweist.

6. Vorrichtung nach einem der Ansprüche 2 bis 5, wobei die die Zündvorrichtung (23) als linearer Hertzscher Oszillator ausgebildet ist, wobei die Wellenlänge des linearen Hertzschen Oszillators gleich der halben, und/oder einem ganzzahligen Vielfachen der halben Wellenlänge des Mikrowellengenerators (23) entspricht und/oder wobei sich der koaxiale Innenleiter in seiner Axialrichtung über den koaxialen Außenleiter hinaus erstreckt und/oder an seinem Ende eine gekrümmte Form aufweist.

7. Vorrichtung zur Halbleiterbearbeitung, die folgendes aufweist:
einen Metallkasten (10), insbesondere aus Aluminium, der einen Prozessraum umschließt, wobei der Metallkasten (10) eine verschließbare Öffnung zum Einführen eines Halbleitersubstrats aufweist,
einen im Prozessraum angeordneten Substrathalter (14a) zur Aufnahme eines Halbleitersubstrats (15),
wenigstens ein im Prozessraum angeordnetes Isolatorrohr (11),
wenigstens eine Elektrode (21, 22, 23) nach einem der Ansprüche 1 bis 6, die wenigstens teilweise so in dem Isolatorrohr (11) aufgenommen ist, dass der wenigstens eine weitere Teil (32) im Isolatorrohr (11) aufgenommen ist, und der koaxiale Außenleiter (22) vorzugsweise über den Randbereich eines sich auf dem Substrathalter befindlichen Halbleitersubstrats (15) hinaus geöffnet ist,
wenigstens eine Einlassöffnung (18) im Metallkasten (10) zum Einleiten von Prozessgas in den Prozessraum, und
wenigstens eine Auslassöffnung (19) im Metallkasten (10) zum Ausleiten von Prozessgas aus dem Prozessraum.

8. Vorrichtung nach Anspruch 7, die ferner eine Vakuumpumpe aufweist, die mit der Auslassöffnung (19) fest verbunden ist, und die geeignet ist den Prozessgasdruck im Prozessraum auf einen Druck von vorzugsweise 1 mTorr bis 20 Torr einzustellen.

9. Vorrichtung nach einem der Ansprüche 7 oder 8, wobei der Substrathalter (14a) drehbar und/oder höhenverstellbar, zum Verändern eines Abstands zwischen Substrathalter und Isolatorrohr (11), im Prozessraum angeordnet ist, und/oder kühlbar und/oder heizbar ist und/oder wenigstens teilweise aus wenigstens einem der folgenden Materialien besteht Aluminiumnitrid, Siliziumnitrid, Quarz und Saphir.

10. Vorrichtung nach einem der Ansprüche 7 bis 9, wobei die Vorrichtung eine Vielzahl von Isolatorrohren (11) im Prozessraum aufweist, die zueinander im wesentlichen parallel in einer Ebene oberhalb und/oder unterhalb des Substrataufnahmebereiches angeordnete sind, und wobei jedes Isolatorrohr (11) wenigstens einen weiteren Teilbereich (32) einer entsprechenden Elektrode (21, 22, 23) umschließt, wobei die Mikrowellenabstrahlleistungen der Elektroden (21, 22, 23) vorzugsweise jeweils einzeln und/oder in Gruppen steuerbar und/oder regelbar sind und wobei einander benachbarte Elektroden (21, 22, 23) optional über jeweils entgegengesetzte Seiten eines entsprechenden Isolatorrohrs (11) mit einer entsprechenden Mikrowellenquelle (20) verbunden sind.

11. Vorrichtung nach einem der Ansprüche 7 bis 10, wobei die Vorrichtung Heizelemente aufweist, die unterhalb und/oder oberhalb des Substrataufnahmebereichs angeordnet sind, wobei die Heizelemente vorzugsweise Halogenlampen und/oder Bogenlampen sind, und/oder wobei die Heizelemente vorzugsweise vom Prozessraum durch Quarzglas und/oder einem mit Fremdatomen dotiertem Quarzglas getrennt sind.

12. Vorrichtung nach einem der Ansprüche 7 bis 11, wobei an der Oberseite des Metallkasten (10) eine zum Prozessraum weisende Isolatorplatte (25) so angeordnet ist, dass sie einen Kontakt eines durch die Mikrowellenplasmavorrichtung erzeugten Plasmas mit der Metallwand verhindert, und/oder wobei der Metallkasten (10) dem Prozessraum zugewandte Oberflächenbereiche aus anodisiertem Aluminium aufweist, und/oder wobei die Vorrichtung eine Elektrode (26) aufweist, die im Prozessraum beabstandet vom Metallkasten (10) oberhalb des Substrataufnahmebereichs angeordnet und vorzugsweise mit der Isolatorplatte (25) fest verbunden ist.

13. Verfahren zur Behandlung eines Halbleitersubstrats in einer Vorrichtung nach einem der Ansprüche 7 bis 12, das die folgenden Schritte aufweist:
a) Einführen des Halbleitersubstrats in den Prozessraum und Ablage des Halbleitersubstrats auf dem im Prozessraum angeordneten Substrathalter;
b) Verschließen der verschließbaren Öffnung des Prozessraums;
c) Abpumpen des Prozessraums;
d) Einleiten von Prozessgas in den Prozessraum;
e) Einleiten von Mikrowellenstrahlung über die Elektroden (21, 22, 23) der Mikrowellenplasmavorrichtung in den Prozessraum und Erzeugen eines Mikrowellenplasmas im Prozessraum;
f) Abschalten der Mikrowellenstrahlung;
g) Belüften der Prozesskammer;
h) Öffnen der verschließbaren Öffnung des Prozessraums; und
i) Herausnehmen des Halbleitersubstrats aus dem Prozessraum.

14. Verfahren nach Anspruch 13, wobei das Halbleitersubstrat vor und/oder während und/oder nach dem Einleiten der Mikrowellenstrahlung innerhalb der Prozesskammer auf eine vorbestimmte Temperatur, die vorzugsweise unter 700°C liegt, aufgeheizt wird, und/oder wobei das Prozessgas aus wenigstens einem der folgenden Gase besteht: Argon, Helium, Sauerstoff, Wasserstoff, Stickstoff, Deuterium und Distickstoffoxid, eine Mischung aus diesen Gasen aufweist und/oder NF₃, CF₄, Cl₂ oder eine Mischung aus diesen Gasen aufweist.

## Claims

1. A microwave plasma apparatus, comprising:
at least one electrode (21, 22, 23) having an attachment end, which is connectable to a microwave generator (20), and a free end, and at least one plasma ignition device (23),
wherein the at least one electrode (21, 22, 23) comprises a coaxial inner conductor (21) made from electrically conductive material as well as a coaxial outer conductor (22) made from electrically conductive material, which at least partially surrounds the coaxial inner conductor and is spaced therefrom,
wherein the coaxial outer conductor (22) comprises in its longitudinal direction at least one first region (31), in which the coaxial outer conductor completely surrounds the coaxial inner conductor, and
wherein the plasma ignition device (23) is connected to the coaxial inner conductor (21),
**characterized in that** the coaxial outer conductor (21) comprises adjacent to the at least one first region at least one further region (32), in which the coaxial outer conductor is formed such that it tapers or narrows in a continuous manner, from said first region (31) to said free end of said at least one electrode, and thus surrounds the coaxial inner conductor (21) less and less, such that microwave radiation generated by the microwave generator (20) may exit from the at least one further region (32) substantially perpendicular to the longitudinal axis of the coaxial inner conductor (21), when the at least one electrode (21, 22, 23) is connected to the microwave generator (20).

2. The microwave plasma apparatus of claim 1, wherein the plasma ignition device (23) is connected to the free end of the coaxial inner conductor (21).

3. The microwave plasma apparatus of one of the preceding claims, wherein the at least one further region (32) is surrounded by a nonconductive material (11) along the longitudinal axis of the coaxial inner conductor (21).

4. The microwave plasma apparatus of claim 3, wherein the nonconductive material (11):
is quartz glass, alumina, or sapphire, and/or
is preferably formed as a hollow cylinder, and/or
preferably surrounds one end of the electrode (21, 22, 23) wherein a space is formed between the nonconductive material and the at least one further region (32), in which preferably ambient air at ambient pressure is present.

5. The microwave plasma apparatus of one of the preceding claims, wherein the coaxial outer conductor comprises an opening (22a, 22b, 22c) having an elliptical or a rhombic form in the at least one further region (32).

6. The microwave plasma apparatus of one of claims 2 to 5, wherein the ignition device (23) is formed as linear Hertz oscillator wherein the wavelength of the linear Hertz oscillator corresponds to half the wavelength of the microwave generator (23) and/or an integer multiple thereof, and/or wherein the coaxial inner conductor extends beyond the coaxial outer conductor in the longitudinal direction thereof, and/or has a curved shape at its end.

7. An apparatus for semiconductor processing, comprising:
a metal box (10), in particular made from aluminium, said metal box surrounding a process chamber and comprising a closable opening for inserting a semiconductor substrate,
a substrate holder (14a) disposed in the process chamber for holding a semiconductor substrate (15),
at least one isolator tube (11) disposed in the process chamber,
at least one electrode (21, 22, 23) of one of claims 1 to 6, which is arranged at least partially in said at least one isolator tube (11) such that at least said further portion (32) is received therein, and the coaxial outer conductor (22) preferably opens beyond the edge region of a substrate (15) received on said substrate holder,
at least one inlet opening (18) in said metal box (10) for introducing process gas into the process chamber; and
at least one outlet opening (19) in said metal box (10) for exhausting process gas from the process chamber.

8. The apparatus of claim 7, further comprising a vacuum pump fixedly connected to the outlet opening (19), said vacuum pump being capable of adjusting the pressure of the process gas in the process chamber preferably to a pressure of from 1 mTorr to 20 Torr.

9. The apparatus of one of claims 7 to 8, wherein the substrate holder (14a):
is rotatably disposed in the process chamber, and/or
is adjustably in height, to vary the distance between the substrate holder and the isolator tube (11), and/or
is coolable and/or heatable, and/or
is at least partially made from one or more of the following materials:
aluminum nitride, silicon nitride, quartz and sapphire.

10. The apparatus of one of claims 7 to 9, comprising a plurality of isolator tubes (11) in the process chamber, which isolator tubes are arranged substantially parallel in a plane above and/or below the substrate holding region, wherein each isolator tube (11) surrounds at least one further region (32) of a respective electrode (21, 22, 23), wherein the microwave radiation power of the electrodes (21, 22, 23) is preferably controllable separately and/or group wise in an open loop and/or closed loop manner and wherein adjacent electrodes (21, 22, 23) are optionally connected to the respective microwave source (20) on opposite sides of the respective isolator tube (11).

11. The apparatus of one of claims 7 to 10, wherein the apparatus further comprises heating elements, which are arranged below and/or above the substrate holding region, wherein said heating elements are preferably halogen lamps and/or arc lamps, and/or wherein said heating elements are separated from the process chamber by quartz glass and/or quartz glass doped with impurity atoms.

12. The apparatus of one of claims 7 to 11, wherein an isolator plate (25) is arranged at the upper side of the metal box such that a contact between a plasma generated by the microwave plasma apparatus and the metal wall is prevented, and/or
wherein the metal box (10) comprises surface regions facing the process chamber which are made from anodized aluminium, and/or
wherein the apparatus comprises an electrode (26), which is arranged in the process chamber spaced from the metal box (10) and above the substrate holding region, and is preferably connected to the isolator plate (25).

13. A method for processing a semiconductor substrate in an apparatus of one of claims 7 to 12, the method comprising the following steps:
a) inserting the semiconductor substrate into the process chamber and placing the semiconductor substrate on the substrate holder disposed in the process chamber;
b) closing the closable opening of the process chamber;
c) evacuating the process chamber;
d) introducing a process gas into the process chamber;
e) introducing microwave radiation via the electrodes (21, 22, 23) of the microwave plasma apparatus into the process chamber and generating a microwave plasma in the process chamber;
f) switching off the microwave radiation;
g) venting the process chamber;
h) opening the closable opening of the process chamber;
i) removing the semiconductor substrate from the process chamber.

14. The method of claim 13, wherein said semiconductor substrate is heated to a predetermined temperature, preferably below 700°C, in said process chamber before and/or during and/or after the step of introducing microwave radiation into the process chamber, and/or
wherein the process gas includes at least one gas selected from the following group: argon, helium, oxygen, hydrogen, nitrogen, deuterium, and nitrous oxide, comprises a mixture of these gases, and/or comprises NF₃, CF₄, Cl₂ or a mixture of these gases.

## Revendications

1. Appareil à plasma micro-ondes, comprenant :
au moins une électrode (21, 22, 23) ayant une extrémité de fixation qui peut être connectée à un générateur de micro-ondes (20), et une extrémité libre, et
au moins un dispositif d'allumage de plasma (23),
dans lequel ladite au moins une électrode (21, 22, 23) comprend un conducteur intérieur coaxial (21) fait d'un matériau conducteur électrique ainsi qu'un conducteur extérieur (22) fait d'un matériau conducteur électrique, qui entoure au moins partiellement le conducteur intérieur coaxial et est espacé de celui-ci,
dans lequel le conducteur extérieur coaxial (22) comprend dans sa direction longitudinale au moins une première région (31), dans laquelle le conducteur extérieur coaxial entoure complètement le conducteur intérieur coaxial, et
dans lequel le dispositif d'allumage de plasma (23) est connecté au conducteur intérieur coaxial (21),
**caractérisé en ce que** le conducteur extérieur coaxial (21) comprend, à côté de ladite au moins une première région, au moins une autre région (32) dans laquelle le conducteur extérieur est formé de telle sorte qu'il soit effilé ou rétréci de façon continue, à partir de la première région (31) vers l'extrémité libre de ladite au moins une électrode, et entoure ainsi le conducteur intérieur coaxial (21) de moins en moins, de sorte que le rayonnement micro-ondes généré par le générateur de micro-ondes (20) peut sortir de ladite au moins une autre région (32) sensiblement perpendiculaire à l'axe longitudinal du conducteur intérieur coaxial (21), lorsque ladite au moins une électrode (21, 22, 23) est connectée au générateur de micro-ondes (20).

2. Appareil à plasma micro-ondes selon la revendication 1, dans lequel le dispositif d'allumage de plasma (23) est connecté à l'extrémité libre du conducteur intérieur coaxial (21).

3. Appareil à plasma micro-ondes selon l'une quelconque des revendications précédentes, dans lequel ladite au moins une autre région (32) est entourée d'un matériau non conducteur (11) suivant l'axe longitudinal du conducteur intérieur coaxial (21).

4. Appareil à plasma micro-ondes selon la revendication 3, dans lequel le matériau non conducteur (11) :
est du verre de quartz, de l'alumine, ou du saphir, et/ou
a de préférence une forme de cylindre creux, et/ou
entoure de préférence une extrémité de l'électrode (21, 22, 23) dans laquelle un espace est formé entre le matériau non conducteur et ladite au moins une autre région (32), dans lequel de préférence de l'air ambiant à pression ambiante est présent.

5. Appareil à plasma micro-ondes selon l'une quelconque des revendications précédentes, dans lequel le conducteur extérieur coaxial comprend une ouverture (22a, 22b, 22c) ayant une forme elliptique ou en losange dans ladite au moins une autre région (32).

6. Appareil à plasma micro-ondes selon l'une quelconque des revendications 2 à 5, dans lequel le dispositif d'allumage (23) est formé comme un oscillateur hertzien linéaire dans lequel la longueur d'onde de l'oscillateur hertzien linéaire correspond à la moitié de la longueur d'onde du générateur de micro-ondes (23) et/ou à un multiple entier de celle-ci, et/ou dans lequel le conducteur intérieur coaxial s'étend au-delà du conducteur extérieur coaxial dans sa direction longitudinale, et/ou a une forme courbe au niveau de son extrémité.

7. Appareil pour le traitement de semi-conducteurs, comprenant :
une boîte métallique (10), en particulier faite en aluminium, la boîte métallique entourant une chambre de traitement et comprenant une ouverture pouvant être fermée pour insérer un substrat semi-conducteur,
un support de substrat (14a) disposé dans la chambre de traitement pour tenir un substrat semi-conducteur (15),
au moins un tube isolant (11) disposé dans la chambre de traitement,
au moins une électrode (21, 22, 23) de l'une quelconque des revendications 1 à 6, qui est agencée au moins partiellement dans ledit au moins un tube isolant (11) de telle sorte que au moins l'autre portion (32) soit reçue dedans, et le conducteur extérieur coaxial (22) débouche de préférence au-delà de la région de bord d'un substrat (15) reçu sur le support de substrat,
au moins une ouverture d'entrée (18) dans la boîte métallique (10) pour introduire un gaz de traitement dans la chambre de traitement ; et
au moins une ouverture de sortie (19) dans la boîte métallique (10) pour faire échapper le gaz de traitement de la chambre de traitement.

8. Appareil selon la revendication 7, comprenant en outre une pompe à vide connectée de façon fixe à l'ouverture de sortie (19), la pompe à vide pouvant ajuster la pression du gaz de traitement dans la chambre de traitement de préférence à une pression comprise entre 1 mTorr et 20 Torr.

9. Appareil selon l'une quelconque des revendications 7 à 8, dans lequel le support de substrat (14a) :
est disposé de façon rotative dans la chambre de traitement, et/ou
est ajustable en hauteur, pour faire varier la distance entre le support de substrat et le tube isolant (11), et/ou
peut être refroidi et/ou chauffé, et/ou est au moins partiellement constitué d'un ou plusieurs des matériaux suivants : nitrure d'aluminium, nitrure de silicium, quartz et saphir.

10. Appareil selon l'une quelconque des revendications 7 à 9, comprenant une pluralité de tubes isolants (11) dans la chambre de traitement, les tubes isolants étant agencés sensiblement parallèles dans un plan au-dessus et/ou en dessous de la région de support de substrat, dans lequel chaque tube isolant (11) entoure au moins une autre région (32) d'une électrode respective (21, 22, 23), dans lequel la puissance du rayonnement micro-ondes des électrodes (21, 22, 23) peut de préférence être contrôlée séparément et/ou en groupe, en boucle ouverte et/ou en boucle fermée, et dans lequel des électrodes adjacentes (21, 22, 23) sont connectées optionnellement à leur source de micro-ondes respective (20) sur des côtés opposés du tube isolant respectif (11).

11. Appareil selon l'une quelconque des revendications 7 à 10, dans lequel l'appareil comprend en outre des éléments chauffants, qui sont agencés en dessous et/ou au-dessus de la région de support de substrat, dans lequel les éléments chauffants sont de préférence des lampes halogènes et/ou des lampes à arc, et/ou dans lequel les éléments chauffants sont séparés de la chambre de traitement par du verre de quartz et/ou du verre de quartz dopé avec des atomes d'impuretés.

12. Appareil selon l'une quelconque des revendications 7 à 11, dans lequel une plaque isolante (25) est agencée au niveau du côté supérieur de la boîte métallique de telle sorte qu'un contact entre du plasma généré par l'appareil à plasma micro-ondes et la paroi métallique est empêché, et/ou
dans lequel la boîte métallique (10) comprend des régions de surface en face de la chambre de traitement qui sont en aluminium anodisé, et/ou
dans lequel l'appareil comprend une électrode (26), qui est agencée dans la chambre de traitement éloignée de la boîte métallique (10) et au-dessus de la région de support de substrat, et est de préférence connectée à la plaque isolante (25).

13. Procédé pour traiter un substrat semi-conducteur dans un appareil de l'une quelconque des revendications 7 à 12, le procédé comprenant les étapes suivantes :
a) insérer le substrat semi-conducteur dans la chambre de traitement et placer le substrat semi-conducteur sur le support de substrat disposé dans la chambre de traitement ;
b) fermer l'ouverture pouvant être fermée de la chambre de traitement ;
c) évacuer la chambre de traitement ;
d) introduire un gaz de traitement dans la chambre de traitement ;
e) introduire un rayonnement micro-ondes par l'intermédiaire des électrodes (21, 22, 23) de l'appareil à plasma micro-ondes dans la chambre de traitement et générer un plasma micro-ondes dans la chambre de traitement ;
f) arrêter le rayonnement micro-ondes ;
g) ventiler la chambre de traitement ;
h) ouvrir l'ouverture pouvant être fermée de la chambre de traitement ;
i) retirer le substrat semi-conducteur de la chambre de traitement.

14. Procédé selon la revendication 13, dans lequel le substrat semi-conducteur est chauffé à une température prédéterminée, de préférence en dessous de 700 °C, dans la chambre de traitement avant et/ou pendant et/ou après l'étape d'introduction de rayonnement micro-ondes dans la chambre de traitement, et/ou
dans lequel le gaz de traitement comprend au moins un gaz sélectionné dans le groupe suivant : argon, hélium, oxygène, hydrogène, azote, deutérium, et oxyde nitreux, ou comprend un mélange de ces gaz et/ou comprend NF₃, CF₄, Cl₂ ou un mélange de ces gaz.
